# FASCICULE DE BREVET EUROPEEN

(11) **EP 1 421 624 B1**
(45) Date de publication et mention de la délivrance du brevet: **11.10.2006**
(21) Numéro de dépôt: 02796333.9
(22) Date de dépôt: 30.08.2002
(51) Int. Cl.: H01L 27/146, H01L 31/0216

(54) **PROCEDE DE FABRICATION DE CAPTEUR D'IMAGE COULEUR AVEC OUVERTURES DE CONTACT CREUSEES AVANT AMINCISSEMENT**
VERFAHREN ZUR HERSTELLUNG EINES FARBBILDSENSORS MIT AUSGESPARTEN KONTAKTAPERTUREN VOR DER AUSDÜNNUNG
METHOD FOR MAKING A COLOUR IMAGE SENSOR WITH RECESSED CONTACT APERTURES PRIOR TO THINNING

(30) Priorité: 31.08.2001 FR 0111336
(43) Date de publication de la demande: 26.05.2004
(73) Titulaire: Atmel Grenoble, 38120 Saint-Egrève (FR)
(72) Inventeur: POURQUIER, Eric, Thales Intellectual Property, F-94117 Arcueil Cedex (FR)
(74) Mandataire: Guérin, Michel
(86) Numéro de dépôt international: PCT/FR2002/002979
(87) Numéro de publication internationale: WO 2003/019669

(56) Documents cités:
- EP-A- 1 094 511
- WO-A-99/40624
- US-A- 5 144 747
- US-A- 5 250 843
- PATENT ABSTRACTS OF JAPAN vol. 007, no. 040 (E-159), 17 février 1983 (1983-02-17) & JP 57 192052 A (MITSUBISHI DENKI KK), 26 novembre 1982 (1982-11-26)

## Description

L'invention concerne les capteurs d'image électroniques, et notamment les capteurs de très petites dimensions permettant de réaliser des caméras miniatures, telles que celles qu'on peut vouloir incorporer à un téléphone portable.

Outre un encombrement très réduit, on souhaite que le capteur d'image ait une bonne sensibilité en faible lumière et de bonnes performances colorimétriques.

D'autre part, il est nécessaire de réaliser l'ensemble de la caméra par des procédés les plus économiques possibles pour ne pas aboutir à un coût rédhibitoire de l'appareil.

Pour y parvenir, on essaye d'une part de réaliser le capteur d'image et les circuits électroniques associés si possible sur un même substrat de silicium, et d'autre part on essaye de réaliser autant que possible les dépôts de couches diverses, les gravures, les traitements thermiques, etc. d'une manière collective sur une tranche de silicium (ou "wafer") comportant de nombreux capteurs identiques, avant de découper la tranche en capteurs individuels. Le document WO-A-9940624 décrit un procédé de fabrication d'un capteur d'image comprenant la formation d'ouvertures métallisées sur la face avant d'une tranche de silicium formant le substrat du capteur.

Cependant, les procédés de fabrication et les structures de capteur d'image qui ont été proposées jusqu'à maintenant ne donnent pas entièrement satisfaction de ce point de vue : les procédés de fabrication ne sont pas industriellement efficaces ; ils restent trop coûteux et de rendement trop faible pour des applications de grande série, ou bien les performances du capteur d'image ne sont pas suffisamment bonnes.

La présente invention vise à proposer un procédé de fabrication et un capteur d'image correspondant qui minimise les coûts de fabrication tout en présentant de bonnes qualités et notamment un faible encombrement, une bonne sensibilité et de bonnes performances colorimétriques.

A cet effet, l'invention propose un procédé de fabrication d'un capteur d'image, comprenant :
- la formation, sur la face avant d'une tranche semiconductrice, de préférence en silicium monocristallin, d'une série de zones actives comportant des circuits de détection d'image et correspondant chacune à un capteur d'image respectif, chaque zone active étant entourée de plots d'entrée/sortie,
- le report de la tranche par sa face avant contre la face avant d'un substrat de support,
- l'élimination de la majeure partie de l'épaisseur de la tranche semiconductrice, laissant subsister sur le substrat une fine couche semiconductrice comprenant les circuits de détection d'image,
ce procédé étant caractérisé en ce que :
- d'une part on dépose et on grave ultérieurement des couches de filtres de couleur sur la tranche semiconductrice ainsi amincie,
- d'autre part, préalablement au report de la tranche semiconductrice sur le substrat, on a formé sur la face avant de la tranche des ouvertures métallisées s'étendant plus profondément que les éléments des circuits de détection d'image formés à la surface de la tranche, et l'élimination de la majeure partie de l'épaisseur de la tranche semiconductrice comporte la mise à nu, par l'arrière, de la métallisation des ouvertures métallisées,
- et enfin, on découpe le substrat en capteurs individuels après le dépôt et la gravure des filtres colorés.

De préférence, les zones actives comprennent à la fois une matrice d'éléments photosensibles, des circuits de commande de la matrice, et des circuits de traitement d'image associés recevant des signaux issus des éléments photosensibles de la zone active. Les circuits ainsi associés à la matrice sont de préférence masqués contre la lumière par une couche d'aluminium, seule la matrice photosensible étant exposée à la lumière.

Le report de la tranche semiconductrice peut se faire par collage, par soudure classique, par soudure anodique (appelée anodic bonding en anglais), ou par simple adhérence moléculaire (force de contact très élevée entre deux surfaces de grande planéité).

L'amincissement de la tranche après report sur le substrat et avant dépôt des filtres colorés peut se faire de plusieurs manières différentes : amincissement par rodage, amincissement chimique, combinaison des deux types (d'abord mécanique puis finition chimique ou encore usinage mécanique en présence de produits chimiques) ; on peut aussi procéder à l'amincissement par fragilisation préalable de la tranche au niveau du plan de coupe désiré, notamment par implantation d'hydrogène en profondeur dans le plan de découpe désiré. Dans ce dernier cas, l'implantation d'hydrogène est faite à faible profondeur dans la tranche semiconductrice, avant le report de la tranche sur le substrat. L'amincissement est fait ensuite par un traitement thermique qui dissocie la tranche au niveau du plan de découpe implanté, laissant une fine couche semiconductrice en contact avec le substrat.

L'amincissement très important de la tranche fait passer l'épaisseur de celle-ci de plusieurs centaines de microns avant report sur le substrat à 3 à 20 micromètres après report sur le substrat. L'amincissement est un facteur de qualité important des capteurs puisqu'il augmente les performances colorimétriques et la sensibilité. Avec des capteurs non amincis, éclairés par le côté où sont formés de multiples couches isolantes et conductrices servant à la définition des circuits de détection d'image, la lumière ayant traversé un filtre coloré est dispersée sur des points photosensibles correspondant à des couleurs différentes, détériorant les performances colorimétriques. De plus, la sensibilité d'un capteur aminci est améliorée parce que les photons arrivent sur une plus large zone de silicium que dans les capteurs non amincis, n'étant pas arrêtés par les couches métalliques qui sont opaques et qui occupent une grande partie de la surface correspondant à chaque point photosensible.

On comprend que l'amincissement complique cependant les problèmes de fabrication du fait qu'après amincissement le semiconducteur, en particulier le silicium, perd sa rigidité et devient très fragile, et que se pose de plus un problème de connexion des circuits de détection d'image avec l'extérieur. La solution selon l'invention permet de pallier cette difficulté et permet de fabriquer des capteurs d'image avec un bon rendement.

Les plots de connexion des capteurs ainsi réalisés se trouvent à l'avant du substrat, du côté où se trouve le silicium aminci, la lumière étant reçue du même côté pour la formation d'une image.

Le substrat et la couche de silicium sont en contact étroit et les éléments de circuit actifs de la tranche sont donc bien protégés de ce côté.

Enfin, sur la couche de silicium amincie, recouverte des filtres de couleur, on peut placer soit une feuille de matière transparente soit une couche de passivation, soit encore des microlentilles en face de chaque capteur. Ces opérations se font de préférence sur le substrat en tranche, avant découpe en capteurs individuels.

A titre d'exemple, l'épaisseur du substrat est d'environ 500 micromètres, pour un substrat de 15 à 20 centimètres de diamètre ; l'épaisseur de la tranche de silicium est de 500 à 1000 micromètres avant amincissement (diamètre de 15 à 30 centimètres), puis de 3 à 20 micromètres après amincissement.

Des couches de planarisation, par exemple en polyimide, peuvent être déposées sur la tranche de silicium avant report sur le substrat.

D'autres caractéristiques et avantages de l'invention apparaîtront à la lecture de la description détaillée qui suit et qui est faite en référence aux dessins annexés dans lesquels :
- la figure 1 représente la structure d'un capteur d'image réalisé sur une tranche de silicium avant mise en place de filtres colorés ;
- la figure 2 représente la formation sur cette tranche d'ouvertures remplies d'une couche de métallisation ;
- la figure 3 représente l'opération de report de la tranche de silicium par sa face avant sur un substrat de support ;
- la figure 4 représente le substrat de support avec la tranche de silicium après amincissement de la tranche ;
- la figure 5 représente le substrat portant une couche de silicium amincie sur laquelle on a déposé une mosaïque de filtres colorés;

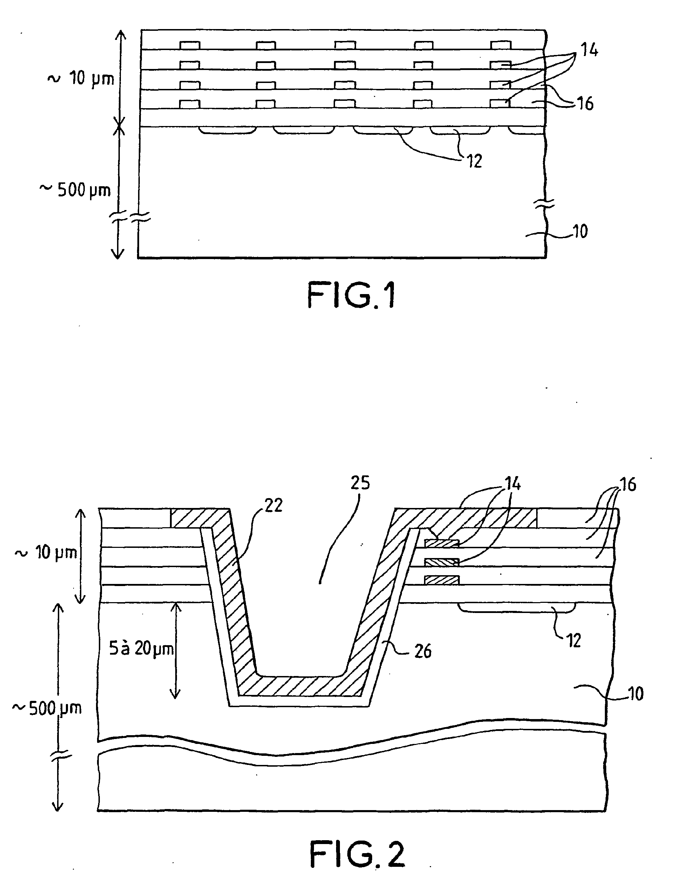

La figure 1 représente la structure générale d'une tranche de silicium sur laquelle on a réalisé par des techniques classiques les circuits de détection d'image d'une multiplicité de capteurs d'image.

La tranche de silicium 10 (ou "wafer") a une épaisseur de plusieurs centaines de micromètres, pour un diamètre de 150 à 300 millimètres par exemple.

Les circuits de détection d'image (matrice de points photosensibles, transistors, interconnexions) sont fabriqués sur une face de la tranche de silicium, qu'on peut appeler face avant et qui est la face supérieure sur la figure 1. La fabrication implique d'une part des diffusions et implantations diverses dans le silicium, à partir de la face supérieure de la tranche, pour former notamment des zones photosensibles 12, et d'autre part des dépôts et gravures successives de couches conductrices 14 et de couches isolantes 16 formant un empilement au dessus des zones photosensibles 12. Les couches isolantes et conductrices font partie des circuits de détection d'image et permettent le recueil des charges électriques engendrées dans les zones photosensibles par une image projetée sur le capteur.

Si le capteur était réalisé avec une technologie classique, on déposerait alors à la surface de la tranche une mosaïque de filtres colorés. Selon l'invention, on ne les dépose pas à ce stade et on effectue des opérations préalables.

Pour chaque capteur d'image individuel formé sur la tranche de silicium, des plots d'entrée/sortie entourent une surface active comportant à la fois une matrice de zones photosensibles et des circuits électroniques associés.

Ces plots d'entrée/sortie (22 sur la figure 2) sont reliés aux couches conductrices 14 et sont formés, dans la présente invention, de la manière suivante : des ouvertures 25 sont creusées dans l'empilement de couches isolantes 16 ainsi que dans la profondeur du substrat de silicium. La profondeur des ouvertures 25 est supérieure à la profondeur de l'ensemble des circuits de détection d'image (zones photosensibles, interconnexions, etc.) formés dans la tranche de silicium. Cette profondeur correspond à peu près à l'épaisseur de silicium qui subsistera après amincissement ultérieur du silicium et qui contiendra ces circuits de détection d'image.

L'amincissement du silicium, qui se fera par l'arrière de la tranche, atteindra en principe exactement le fond des ouvertures 25. Toutefois, on verra que la profondeur des ouvertures 25 peut être légèrement différente de l'épaisseur désirée pour le silicium aminci. Typiquement, la profondeur des ouvertures 25 est de l'ordre de 5 à 20 microns à l'intérieur du silicium de la tranche, c'est-à-dire environ 15 à 30 micromètres au dessous de la surface de l'empilement de couches conductrices et isolantes 14, 16.

Dans les ouvertures 25, on forme de préférence d'abord une couche isolante 26. Puis on dépose et on grave une couche métallique qui formera les plots de connexion 22. Ces plots de connexions viennent contacter une des couches conductrices 14. Si pour cela il faut faire des ouvertures de mise à nu locale d'une couche 14, on creuse localement les couches isolantes 16 qui recouvrent la couche 14 avant le dépôt de la couche métallique dans l'ouverture 25.

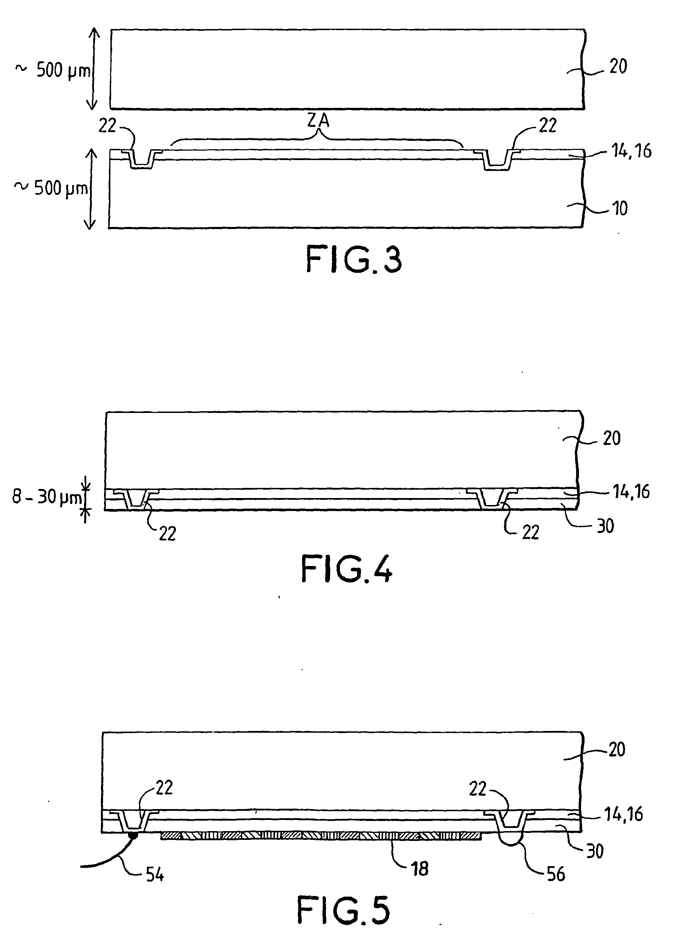

A ce stade, on ne dépose toujours pas de filtres colorés, mais on reporte la tranche par sa face avant sur un substrat 20 (figure 3). Le substrat est une tranche de même diamètre que la tranche 10 et d'épaisseur analogue pour assurer la rigidité de la structure pendant la fabrication ; il peut d'ailleurs être constitué par une autre tranche de silicium ; le report peut être effectué après dépôt d'une couche de "planarisation" servant à combler les reliefs créés sur la face avant de la tranche de silicium par les opérations de dépôt et gravure de l'empilement de couches conductrices et isolantes. Cette couche de planarisation n'a pas besoin d'être transparente.

Sur la figure 3, on a représenté la structure à une échelle plus petite qu'à la figure 1, pour montrer l'ensemble d'un capteur individuel comportant une zone active ZA et des plots de connexion 22 autour de la zone active ZA.

Le report de la tranche de silicium sur la tranche de support 20 peut se faire par plusieurs moyens, le moyen le plus simple pouvant être tout simplement un maintien par adhérence moléculaire, la grande planéité des surfaces en contact engendrant des forces de contact très élevées. Un collage est possible également. Une soudure par l'intermédiaire des plots de connexion 22 et de plots correspondants préalablement formés dans le substrat 20 est également possible. Dans ce cas, on peut d'ailleurs envisager que le substrat 20 comporte des éléments de circuits actifs ou passifs auxiliaires, reliés à ces plots, et pouvant donc être connectés directement au capteur d'image.

Après report de la tranche de silicium par sa face avant sur la tranche de support, on élimine la majeure partie de l'épaisseur de la tranche de silicium 10 pour n'en laisser subsister qu'une épaisseur d'environ 8 à 30 micromètres, incluant l'épaisseur de l'empilement de couches 14, 16. Ce qui subsiste de la tranche de silicium n'est plus qu'une superposition de quelques micromètres (par exemple une dizaine) pour l'empilement de couches 14, 16 et environ 3 à 20 micromètres pour l'épaisseur de silicium subsistante, incluant les zones photosensibles 12. L'épaisseur subsistante est la couche 30 de la figure 4 contenant les zones photosensibles 12 de la figure 1.

L'amincissement fait apparaître la métallisation des plots de connexion 22 pour que ceux-ci deviennent électriquement accessibles par la face arrière de la tranche de silicium (la face avant étant la face supérieure sur la figure 1, tournée vers le haut et recouverte du substrat 20 sur les figures 4 et 5).

Si l'amincissement va légèrement plus loin que la partie la plus profonde de la métallisation, il faut qu'il laisse subsister une partie de cette métallisation pour rendre possible un accès. Si l'amincissement va légèrement moins loin (quelques micromètres) que la partie la plus profonde de la métallisation, on peut envisager d'ouvrir ultérieurement par la face arrière du silicium aminci, des ouvertures d'accès mettant à nu les métallisations 22.

L'opération d'amincissement peut se faire par usinage mécanique (rodage) terminé par un usinage chimique, ou par usinage chimique uniquement, ou par usinage mécanique en présence de produits chimiques, ou encore par un procédé de séparation particulier nécessitant au préalable une implantation d'une impureté de fragilisation dans le plan qui délimitera la couche de silicium amincie.

Dans le cas de cette séparation par implantation d'impuretés, il faut effectuer l'implantation avant le report de la tranche de silicium sur la tranche de support. En effet, l'implantation se fait par la face avant de la tranche de silicium, sur toute la surface de celle-ci et à une profondeur qui définira le plan de découpe. L'implantation préalable est de préférence une implantation d'hydrogène. Elle peut être effectuée à divers stades de la fabrication de la tranche, mais la séparation de l'épaisseur de la tranche selon le plan de découpe implanté ne se fait que lorsque la tranche de silicium a été rapportée sur la tranche de support.

La surface supérieure de la couche de silicium amincie 30 peut être traitée (rodage fin, nettoyage chimique, polissage mécano-chimique, etc.) pour éliminer les défauts de surface, aboutissant à une tranche de multiples capteurs dont la structure générale est celle de la figure 4.

Une mosaïque de filtres colorés 18 est alors déposée sur la surface de la couche 30 (figure 5). Cependant, on peut déposer, avant les filtres colorés, des couches supplémentaires et notamment des couches de passivation, des couches anti-reflets, des couches d'activation électrique, etc.

Un film de verre, ou une lentille individuelle pour le capteur d'image, ou une matrice de microlentilles de même pas d'espacement que les filtres colorés 18 peuvent être déposés sur la face arrière (celle qui sera éclairée) de la structure après dépôt et gravure des filtres colorés.

Les plots de connexion qui ont laissés à nu par l'opération d'amincissement peuvent servir pour une connexion de type "wire-bonding" (soudure de fils 54 sur les plots) ou de type "flip-chip" (puce retournée avec les plots de connexion contre des plots correspondants d'une carte de circuit imprimé avec des bossages conducteurs intermédiaires 56). Dans ce dernier cas, l'éclairement du capteur se fait par le dessous de la carte de circuit imprimé et il faut que la carte comporte une ouverture en regard de la matrice photosensible.

Dans ces différents modes de réalisation, la structure formée sur le substrat 40 peut être testée sur tranche par l'intermédiaire des plots de connexion. Le test peut être fait en présence de lumière, de motifs d'image, etc.

La structure n'est découpée en capteurs individuels en vue d'une encapsulation qu'à la fin de ce processus de fabrication.

## Revendications

1. Procédé de fabrication d'un capteur d'image, comprenant :
- la formation, sur la face avant d'une tranche de silicium (10), d'une série de zones actives (ZA) comportant des circuits de détection d'image et correspondant chacune à un capteur d'image respectif, chaque zone active étant entourée de plots d'entrée/sortie (22),
- le report de la tranche par sa face avant contre la face avant d'un substrat de support (20),
- l'élimination de la majeure partie de l'épaisseur de la tranche de silicium, laissant subsister sur le substrat une fine couche de silicium (30) comprenant les circuits de détection d'image,
ce procédé étant **caractérisé en ce que** :
- d'une part on dépose et on grave ultérieurement des couches de filtres colorés (18) sur la tranche de silicium ainsi amincie,
- d'autre part, préalablement au report de la tranche de silicium sur le substrat, on a formé sur la face avant de la tranche de silicium des ouvertures métallisées (25) s'étendant plus profondément que les éléments des circuits de détection d'image formés à la surface de la tranche semiconductrice, et l'étape d'élimination de la majeure partie de l'épaisseur de la tranche semiconductrice comporte la mise à nu, par l'arrière du substrat, de la métallisation (22) des ouvertures métallisées,
- et enfin, on découpe le substrat en capteurs individuels après le dépôt et la gravure des filtres colorés.

2. Procédé selon la revendication 1, **caractérisé en ce que** l'épaisseur subsistante de la couche semiconductrice amincie est d'environ 3 à 20 micromètres environ.

3. Procédé selon l'une des revendications 1 et 2, **caractérisé en ce que**, sur la couche semiconductrice amincie recouverte des filtres de couleur, on place une feuille de matière transparente.

## Claims

1. Process for fabricating an image sensor, comprising:
- the formation, on the front face of a silicon wafer (10), of a series of active zones (AZ) that includes image detection circuits, each active zone corresponding to a respective image sensor and being surrounded by input/output pads (22);
- the bonding of the wafer via its front face to the front face of a support substrate (20); and
- the elimination of most of the thickness of the silicon wafer, leaving behind on the substrate a thin silicon layer (30) comprising the image detection circuits,
this process being **characterized in that**:
- on the one hand, colour filter layers (18) are deposited on the silicon wafer thus thinned and are subsequently etched;
- on the other hand, before the silicon wafer is bonded to the substrate, metallized apertures (25) are formed on the front face of the silicon wafer, said apertures extending more deeply than the elements of the image detection circuits formed on the surface of the semiconductor wafer, and the step of eliminating most of the thickness of the semiconductor wafer comprises the baring, via the rear of the substrate, of the metallization (22) of the metallized apertures; and
- finally, the substrate is cut up into individual sensors after the colour filters have been deposited and etched.

2. Process according to Claim 1, **characterized in that** the remaining thickness of the thinned semiconductor layer is from about 3 microns to about 20 microns.

3. Process according to either of Claims 1 and 2, **characterized in that** a sheet of transparent material is placed on the thinned semiconductor layer covered with the colour filters.

## Patentansprüche

1. Verfahren zur Herstellung eines Bildsensors, das Folgendes umfasst:
- Bildung einer Reihe aktiver Zonen (AZ) auf der Vorderfläche eines Siliziumwafers (10), die Bilderfassungsschaltungen aufweisen und jeweils einem jeweiligen Bildsensor entsprechen, wobei jede aktive Zone von Eingangs-/Ausgangskontakten (22) umgeben ist,
- Ausrichtung des Wafers mit seiner Vorderfläche auf die Vorderfläche eines Trägersubstrats (20),
- Entfernung des Großteils der Dicke des Siliziumwafers, so dass auf dem Substrat nur eine dünne Schicht Silizium (30) bleibt, die die Bilderfassungsschaltungen umfasst,
das **dadurch gekennzeichnet ist, dass**:
- danach einerseits auf dem dergestalt dünner gemachten Siliziumwafer Schichten aus Farbfiltern (18) abgeschieden und darauf aufgeprägt werden,
- andererseits vor der Ausrichtung des Siliziumwafers auf dem Substrat an der Vorderseite des Siliziumwafers metallisierte Öffnungen (25) ausgebildet wurden, die sich tiefer erstrecken als die an der Oberfläche des Halbleiterwafers gebildeten Elemente der Erfassungsschaltungen und der Schritt des Entfernens des Großteils der Dicke des Halbleiterwafers die Freilegung der Metallisierung (22) der metallisierten Löcher von der Rückseite des Substrats aus umfasst,
- das Substrat nach der Abscheidung und dem Aufprägen von Farbfiltern schließlich in einzelne Sensoren zerteilt wird.

2. Verfahren nach Anspruch 1, **dadurch gekennzeichnet, dass** die verbleibende Dicke der dünner gemachten Halbleiterschicht ungefähr 3 bis ungefähr 20 Mikrometer beträgt.

3. Verfahren nach einem der Ansprüche 1 und 2, **dadurch gekennzeichnet, dass** auf der mit Farbfiltern bedeckten dünner gemachten Halbleiterschicht ein Bogen transparenten Materials platziert wird.
